# EUROPEAN PATENT SPECIFICATION

(11) **EP 3 428 930 B1**
(45) Date of publication and mention of the grant of the patent: **11.03.2020**
(21) Application number: 17203322.7
(22) Date of filing: 23.11.2017
(51) Int. Cl.: H01B 3/00, H01B 3/20, H02H 3/087, H02H 7/22, H03K 17/687

(54) **INSULATING LIQUID AND ELECTRICAL DEVICE FOR CONNECTION TO A HIGH-VOLTAGE GRID**
ISOLIERFLÜSSIGKEIT UND ELEKTRISCHE VORRICHTUNG ZUM ANSCHLUSS AN EIN HOCHSPANNUNGSNETZ
LIQUIDE ISOLANT ET DISPOSITIF ÉLECTRIQUE POUR LA CONNEXION À UN RÉSEAU À HAUTE TENSION

(30) Priority: 14.07.2017 EP 17181402
(43) Date of publication of application: 16.01.2019
(73) Proprietor: Siemens Aktiengesellschaft, 80333 München (DE); Oleon N.V., 9940 Ertvelde (BE)
(72) Inventor: Atanasova-Höhlein, Ivanka, 90762 Fürth (DE); Chavhan, Satyanarayan, 90403 Nürnberg (DE); Ghysel, Maarten Geert Klaas, 9160 Lokeren (BE); Van Hecke, Lieven Charles Maria, 8500 Kortrijk (BE)

(56) References cited:
- WO-A1-00/34409
- WO-A1-98/31021
- US-A- 3 811 077
- US-A1- 2008 283 803
- US-A1- 2011 232 940

## Description

The present invention relates to an insulating liquid for an electrical high-voltage device and a method for preparing such a liquid.

Furthermore, the invention relates to an electrical device for connection to a high-voltage grid.

Insulating liquids are used in electrical high-voltage devices such as for example transformers and coils.

Ester-based insulating liquids have considerable advantages in comparison to since long time established mineral oils. They exhibit, a better biodegradability with no adverse toxic environmental or aquatic side-effects. Importantly, they have better properties concerning paper degradation, higher flash and fire point as pointed out in Cigre brochure 436 (2010) and US 7,815,821.

Ester-based dielectric fluids are highly hygroscopic when compared to mineral oils. This means that the fluid will be able to retain a good dielectric strength, even when contaminated with relatively high levels of moisture. However, existing ester insulating liquids on natural basis, e.g. acc. IEC 62770 have a quite high pour point and viscosities which require a changed thermal design of the electrical device, as well as special precautions in the case of cold start. Furthermore, some of them have low intrinsic oxidation stability due to double bonds in the structure.

Existing ester insulating liquids based on mono-carbonic acids and Polyol (e. g. IEC 61099) may have a better pour point than natural esters, however nevertheless very high viscosities in comparison to mineral oil.

The US 3,811,077 discloses a capacitor having a housing filled with insulating fluid. The said insulating fluid is a mixture of tolylsylsulfone and carboxylic acid esters. Further general state of the art documents are US 2008/28303 A1, WO 00/34409 A1, US 2011/232940 A1 and WO 98/31021 A1.

Viscosity is a major insulating fluid property concerning thermal design of an electrical device the insulating liquid is used for. Such an electrical device, i.e. a coil or transformer, is equipped with tank in which an active part is disposed. The active part comprises a core and at least one winding surrounding a section of the core. In operation the active part is connected with a high-voltage power grid. In order to increase the electrical strength of the device, the tank is filled with an insulation fluid. Besides the insulation the insulating fluid cools the active part during operation. The heat transfer involved strongly depends on the properties of the selected insulating liquid. Most relevant properties in this regard are the viscosity, density, thermal conductivity and specific heat capacity of the insulating fluid. Low viscosity esters exhibit better cooling properties and can be utilized for an improved thermal design of the high-voltage device.

Therefore, it is an object of the present invention to provide an insulating liquid with low viscosity which can be used in an electrical device which is connected to a high-voltage power grid.

The invention achieves the aforementioned object by an insulating liquid for an electrical device comprising at least one dicarboxylic acid according to the formula HOOC-(CH₂)ₙ- COOH, with 2 ≤ n ≤ 10, esterified with an alcohol having between 6 and 12 carbon hydrogen groups and at least one functional OH-group, an antioxidant and a passivator.

The invention also achieves the aforementioned object by an electrical device for connection to a high-voltage grid, the electrical device having a tank and a core with at least one winding disposed in said tank. According to the invention the tank is filled with an insulating liquid as defined above.

The present invention is based on the realisation that a low viscous ester-based dielectric fluid can be obtained by blending a dibasic ester with at least one antioxidant and a passivator. The inventors have found that the viscosity of a dielectric fluid can be favourably reduced to within convenient limits comparable to the viscosity of mineral oil, by preparing dibasic esters based on dicarboxylic acids esterified with mono- or polyalcohols with straight or branched hydrocarbon chain or a mixture thereof.

According to the invention the dibasic ester is the result of an esterification or esterification reaction between dicarboxylic acids of 2 to 10 carbon atoms and mono- or polyalcohols with straight or branched hydrocarbon chain or a mixture thereof. Preference is attributed to saturated substituents to achieve the required oxidation stability.

According to a preferred embodiment of the invention the quantity of antioxidant is between 0.01 and 1% by weight and more particularly, is between 0.05% and 0.5% by weight.

The antioxidant is preferably selected from the group which includes but is not limited to, alkyl phenols, amino phenol, amines from the phenolic type and tocopherols.

The preferred quantity of metal passivator is between 0.001% and 1% by weight and more preferred between 0.005% and 0.2%.

The metal passivator or metal desactivator is preferably an organic hetero-compound selected from the group consisting of triazoles, benzotriazols, tolyltriazoles, and mixtures of the substances mentioned.

According to a most preferred embodiment of the invention the ester is di(2-ethylhexyl)sebacate/sucinate or di(2-octanyl)sebacate/succinate using sebacic acid and 2-ethylhexanol or 2-octanole for esterification.

The invention also relates to a method of preparing an insulating liquid comprising the steps of mixing at least one dicarboxylic acid according to the formula HOOC-(CH₂)ₙ- COOH, with 2 ≤ n ≤ 10, and an alcohol having between 6 and 12 carbon hydrogen groups and at least one functional OH-group; increasing the temperature of the mixture up to a range between 140°C and 160°C; gradually increasing the temperature of the mixture up to a range between 180°C and 190°C while removing the water produced during the reaction until the acid value stabilizes below a predetermined acid threshold value; cooling the mixture down to a range between 60°C-90°C; neutralizing the mixture and removing residual water; and adding an antioxidant and a passivator.

According to a preferred example a resin catalyst is added to the mixture of the at least one dicarboxylic acid and the alcohol. Preferably the resin catalyst is filtered to eliminate the acid resin catalyst ahead of the neutralizing step.

According to a preferred embodiment the acid threshold value is 0.5 mg KOH/g.

Furthermore, the invention also relates to an electrical device for connection to a high-voltage grid, the electrical device having a tank; and a core with at least one winding disposed in said tank; characterized in that the tank is filled with an insulating liquid according to one of the preceding claims.

The present invention will be described more specifically by the following illustrating method for producing an insulating liquid according to the invention. However, the present invention is not limited to this esterification process. The dibasic ester may be prepared via a conventional esterification process by heating diacid with at least a stoichiometric amount of alcohol.

In a four-necked reactor flask provided with a mechanical stirrer, a thermometer, a nitrogen inlet tube and a condenser, 2. mol of an alcohol 1 mol of a dicarboxylic acid and 3 % of acid resin catalyst (AMBERLYST 70) was introduced. The use of solid catalyst beads is suitable for this application as it can easily be removed after reaction and no residual catalyst remains in the product which can have a negative impact on the DDF. The reaction was conducted atmospheric pressure under a nitrogen stream. The temperature of the reaction mixture was brought rapidly to 150°C, then it was gradually increased at a rate of 10°C/hour) up to 190°C while removing water that was produced during the condensation reaction by distillation.

When the acid value stabilizes to a value less than 0.5 mg KOH/g, the reaction mixture was cooled down to 80°C and filtered with filter paper in order to eliminate the catalyst.

The crude esterified product is then poured back into the reactor and heated at 80°C in order to neutralize the free carboxylic acid function by adding a stoichiometric amount of a 50% sodium hydroxide aqueous solution, and the mixture was stirred for at least 30 minutes. The neutralisation step is important to ensure that no residual acid are remaining which could cause product instability (e. g. hydrolysis of the ester). Then the reaction vessel is being kept under maximum vacuum (10mBar) in order to eliminate residual water by nitrogen stripping to prevent the risk of hydrolyses.

After neutralization and drying process is completed, the crude mixture filtered through a sintered filter in the presence of 1% of a silicate filter aid (SIPERNAT® 50 silica).

Thus a dibasic ester having an acid value of max 0.03 mg KOH/g was obtained as a final product. As an example bis-2-ethylhexyl succinate, bis-2-ethylhexyl sebacate and bis-2-octyl succinate have been prepared according to above mentioned method.

To ensure a good dispersion of the additives, it requires heating up to 80°C and mixing to dissolve in the ester the additives under nitrogen atmosphere.

In a preferred example the following additives are used: Irgamet 30, manufactured by the company BASF (10 to 10000 ppm) as yellow metal deactivator, which is a triazole derivative, and Irganox L109 also produced by BASF, which is an antioxidant of phenolic type (0.01 to 1%).

The insulating fluid according to the invention has the following advantages:
- Very low pour point;
- High flash and fire point;
- Low viscosity at low temperature and therefore an improved cooling behaviour compared to mineral oils;
- At high temperatures the viscosity is comparable to mineral oil and much better than ester fluids according to the state of the art;
- Improved oxidation stability over natural esters;
- High biodegradability

## Claims

1. Insulating liquid for an electrical device comprising
- at least one dicarboxylic acid according to the formula HOOC-(CH₂)ₙ- COOH, with 2 ≤ n ≤ 10, esterified with an alcohol having between 6 and 12 carbon hydrogen groups and at least one functional OH-group,
- an antioxidant and
- a passivator.

2. Insulating liquid according to claim 1, wherein the amount of antioxidant varies between 0.01 % and 1% by weight and more particularly, between 0.05% and 0.5% by weight.

3. Insulating liquid according to claim 1 or 2, wherein the antioxidant is preferably selected from the group including alkyl phenols, amino phenol, amines of the phenolic type and tocopherols.

4. Insulating liquid according to one of the preceding claims wherein the amount of passivator varies between 0.001% and 1% by weight and more particularly between 0.005% and 0.2%.

5. Insulating liquid according to one of the preceding claims wherein passivator or metal desactivator is preferably an organic hetero compound selected from the group consisting of triazoles, benzotriazols, tolyltriazoles, and mixtures of the substances mentioned.

6. Insulating liquid according to one of the preceding claims wherein the dicarboxylic acid is sebacic acid esterfied with 2-Ethylhexanol or 2-ocanole to yield di(2-ethylhexyl)sebacate/succinate and di(2-octanyl)sebacate/succinate, respectively.

7. Electrical device for connection to a high-voltage grid, the electrical device having
a tank; and
a core with at least one winding disposed in said tank;
**characterized in that**
the tank is filled with an insulating liquid according to one of the preceding claims.

8. Method of preparing an insulating liquid comprising the steps of:
- Mixing at least one dicarboxylic acid according to the formula HOOC-(CH₂)ₙ- COOH, with 2 ≤ n ≤ 10, and an alcohol having between 6 and 12 carbon hydrogen groups and at least one functional OH-group;
- Increasing the temperature of the mixture in a range between 140°C and 160°C;
- Gradually increasing the temperature of the mixture in a range between 180°C and 190°C while removing the water produced during the reaction until the acid value stabilizes below a predetermined acid threshold value;
- Cooling the mixture down between 60°C-90°C;
- Neutralizing the mixture and removing residual water; and
- Adding an antioxidant and a passivator.

9. Method according to claim 7 **characterized in that** an acid resin catalyst is added to the mixture of the at least one dicarboxylic acid and the alcohol.

10. Method according to claim 8 **characterized in that** the mixture is filtered to eliminate the acid resin catalyst before neutralizing the mixture.

11. Method according to one of the claim 7 to 8 **characterized in that** the acid threshold value is 0.5 mg KOH/g.

## Patentansprüche

1. Isolierflüssigkeit für eine elektronische Vorrichtung, umfassend
- mindestens eine Dicarbonsäure gemäß der Formel HOOC-(CH₂)ₙ-COOH mit 2 ≤ n ≤ 10, die mit einem Alkohol mit zwischen 6 und 12 Kohlenstoff-Wasserstoff-Gruppen und mindestens einer funktionellen OH-Gruppe verestert ist,
- ein Antioxidans und
- einen Passivator.

2. Isolierflüssigkeit nach Anspruch 1, wobei die Menge an Antioxidans zwischen 0,01 und 1 Gew.-% und spezieller zwischen 0,05 und 0,5 Gew.-% variiert.

3. Isolierflüssigkeit nach Anspruch 1 oder 2, wobei das Antioxidans vorzugsweise aus der Gruppe enthaltend Alkylphenole, Aminophenol, Amine vom phenolischen Typ und Tocopherole ausgewählt ist.

4. Isolierflüssigkeit nach einem der vorhergehenden Ansprüche, wobei die Menge an Passivator zwischen 0,001 und 1 Gew.-% und spezieller zwischen 0,005 und 0,2 % variiert.

5. Isolierflüssigkeit nach einem der vorhergehenden Ansprüche, wobei es sich bei dem Passivator oder Metalldesaktivator vorzugsweise um eine organische Heteroverbindung aus der Gruppe bestehend aus Triazolen, Benzotriazolen, Tolyltriazolen und Mischungen der genannten Substanzen handelt.

6. Isolierflüssigkeit nach einem der vorhergehenden Ansprüche, wobei es sich bei der Dicarbonsäure um Sebacinsäure, die mit 2-Ethylhexanol oder 2-Octanol unter Erhalt von Di(2-ethylhexyl)sebacat/succinat bzw. Di(2-octanyl)sebacat/succinat verestert ist, handelt.

7. Elektrische Vorrichtung zum Anschluss an ein Hochspannungsnetz, wobei die elektrische Vorrichtung einen Tank und
einen in dem Tank angeordneten Kern mit mindestens einer Wicklung
aufweist;
**dadurch gekennzeichnet, dass** der Tank mit einer Isolierflüssigkeit nach einem der vorhergehenden Ansprüche gefüllt ist.

8. Verfahren zur Herstellung einer Isolierflüssigkeit, das folgende Schritte umfasst:
- Mischen von mindestens einer Dicarbonsäure gemäß der Formel HOOC-(CH₂)ₙ-COOH mit 2 ≤ n ≤ 10 und einem Alkohol mit zwischen 6 und 12 Kohlenstoff-Wasserstoff-Gruppen und mindestens einer funktionellen OH-Gruppe;
- Erhöhen der Temperatur der Mischung in einem Bereich zwischen 140 °C und 160 °C;
- allmähliches Erhöhen der Temperatur der Mischung in einem Bereich zwischen 180 °C und 190 °C und Entfernung des bei der Reaktion gebildeten Wassers bis zur Stabilisierung der Säurezahl unterhalb einer vorbestimmten Schwellen-Säurezahl;
- Abkühlen der Mischung auf zwischen 60 °C-90 °C;
- Neutralisieren der Mischung und Entfernen von Wasserresten; und
- Zugeben eines Antioxidans und eines Passivators.

9. Verfahren nach Anspruch 7, **dadurch gekennzeichnet, dass** ein saurer Harzkatalysator zu der Mischung der mindestens einen Carbonsäure und des Alkohols gegeben wird.

10. Verfahren nach Anspruch 8, **dadurch gekennzeichnet, dass** die Mischung zur Entfernung des sauren Harzkatalysators vor dem Neutralisieren der Mischung filtriert wird.

11. Verfahren nach einem der Ansprüche 7 bis 8, **dadurch gekennzeichnet, dass** die Schwellen-Säurezahl 0,5 mg KOH/g beträgt.

## Revendications

1. Liquide isolant pour un dispositif électrique, comprenant
- au moins un acide dicarboxylique de formule HOOC-(CH₂)ₙ- COOH, avec 2 ≤ n ≤ 10, estérifié par un alcool ayant entre 6 et 12 groupes hydrocarbonés et au moins un groupe OH fonctionnel,
- un antioxydant et
- un passivant.

2. Liquide isolant suivant la revendication 1, dans lequel la quantité d'antioxydant varie entre 0,001% et 1% en poids, et plus particulièrement entre 0,05% et 0,5% en poids.

3. Liquide isolant suivant la revendication 1 ou 2, dans lequel l'antioxydant est choisi de préférence dans le groupe comprenant des alcoylphénols, des aminophénols, des amines du type phénolique et des tocophérols.

4. Liquide isolant suivant l'une des revendications précédentes, dans lequel la quantité de passivant varie entre 0,001% et 1% en poids, et plus particulièrement entre 0,005% et 0,2%.

5. Liquide suivant l'une des revendications précédentes, dans lequel le passivant ou désactivant de métal est, de préférence, un composé hétéro organique choisi dans le groupe consistant en des triazoles, des benzotriazoles, des tolyltriazoles et des mélanges des substances mentionnées.

6. Liquide suivant l'une des revendications précédentes, dans lequel l'acide dicarboxylique et l'acide sébacique estérifié par le 2-éthylhexanol ou le 2-octanol pour donner du sébacate/succinate de di(2-éthylhexyle) et du sébacate/succinate de di(2-octanyle), respectivement.

7. Dispositif électrique pour une connexion à un réseau de haute tension, le dispositif électrique ayant
une cuve ; et
un noyau ayant au moins un enroulement disposé dans la cuve ;
**caractérisé en ce que**
la cuve est remplie d'un liquide isolant suivant l'une des revendications précédentes.

8. Procédé de préparation d'un liquide isolant comprenant les stades de :
- mélange d'au moins un acide dicarboxylique de formule HOOC-(CH₂)ₙ-COOH, avec 2 ≤ n ≤ 10, et d'un alcool ayant entre 6 et 12 groupes hydrocarbonés et au moins un groupe OH fonctionnel ;
- élévation de la température du mélange dans une plage comprise entre 140°C et 160°C ;
- élévation graduelle de la température du mélange dans une plage comprise entre 180°C et 190°C, tout en éliminant l'eau produite pendant la réaction jusqu'à ce que l'indice d'acide se stabilise en dessous d'une valeur de seuil d'acide déterminée à l'avance ;
- refroidissement du mélange entre 60°C et 90°C ;
- neutralisation du mélange et élimination d'eau résiduelle ; et
- addition d'un antioxydant et d'un passivant.

9. Procédé suivant la revendication 7, **caractérisé en ce que** l'on ajoute un catalyseur en résine acide au mélange du au moins un acide dicarboxylique et de l'alcool.

10. Procédé suivant la revendication 8, **caractérisé en ce que** l'on filtre le mélange pour éliminer le catalyseur en résine acide avant de neutraliser le mélange.

11. Procédé suivant l'une des revendications 7 à 8, **caractérisé en ce que** la valeur de seuil d'acide est de 0,5 mg de KOH/g.
